# EUROPÄISCHE PATENTSCHRIFT

(11) **EP 1 211 518 B1**
(45) Veröffentlichungstag und Bekanntmachung des Hinweises auf die Patenterteilung: **26.04.2006**
(21) Anmeldenummer: 01000678.1
(22) Anmeldetag: 29.11.2001
(51) Int. Cl.: G01R 33/3415

(54) **MR-Bildrekonstruktion**
Reconstruction of MR images
Reconstruction d'images RM

(30) Priorität: 30.11.2000 DE 10059772
(43) Veröffentlichungstag der Anmeldung: 05.06.2002
(73) Patentinhaber: Philips Intellectual Property & Standards GmbH, 20099 Hamburg (DE); Koninklijke Philips Electronics N.V., 5621 BA Eindhoven (NL)
(72) Erfinder: Katscher, Ulrich Dr., c/o Philips Corp. I.P.GmbH, 52064, Aachen (DE)
(74) Vertreter: Volmer, Georg

(56) Entgegenhaltungen:
- "MR-Imaging" RESEARCH DISCLOSURE 429053, 10. Januar 2000 (2000-01-10), XP000976393
- W.E. KYRIAKOS ET AL.: "Sensitivity Profiles From an Array of Coils .." MAGNETIC RESONANCE IN MEDICINE, Bd. 44, Seiten 301-308, XP000947389
- K.P. PRUESSMANN ET AL.: "SENSE: Sensitivity Encoding ..." MAGNETIC RESONANCE IN MEDICINE, Bd. 42, 1999, Seiten 952-962, XP000866655

## Beschreibung

Die Erfindung betrifft ein MR-Bildgebungsverfahren, bei dem eine Anzahl von MR-Datensätzen zu einem Bild der Kernmagnetisierungsverteilung in einem Untersuchungsbereich kombiniert wird, wobei ausgenutzt wird, dass jedem MR-Datensatz ein räumliches Empfindlichkeitsprofil eines für die Akquisition des jeweiligen MR-Datensatzes verwendeten Empfangselementes zugeordnet ist. Die Erfindung betrifft ferner ein MR-Gerät zur Durchführung des Verfahrens sowie ein Computerprogramm zur Steuerung eines MR-Gerätes.

Bei der MR-Bildgebung ist es allgemein üblich, das Kernspinsignal als Spannung, die in einer den Untersuchungsbereich umgebenden Spule induziert wird, unter dem Einfluss einer geeigneten Abfolge (Sequenz) von Hochfrequenz- und Gradientenpulsen in der Zeitdomäne aufzuzeichnen. Die eigentliche Bildrekonstruktion erfolgt dann durch Fouriertransformation der Zeitsignale. Durch die Zahl, den zeitlichen Abstand, die Dauer und die Stärke der verwendeten Gradientenpulse ist die Abtastung des reziproken k-Raumes vorgegeben, durch welchen der abzubildende Volumenbereich (FOV, Field of View) sowie die Bildauflösung bestimmt sind. Durch Anforderungen an die Bildgröße und Bildauflösung wird die Zahl der Phasenkodierungsschritte und damit die Dauer der Bildgebungssequenz vorgegeben. Daraus ergibt sich unmittelbar einer der wesentlichen Nachteile der Kernspintomographie, da die Aufnahme eines Bildes des kompletten Untersuchungsbereiches in einer für diagnostische Zwecke ausreichenden Auflösung meist eine unerwünscht lange Zeit in Anspruch nimmt.

Eine große Zahl von technischen Weiterentwicklungen im Bereich der Kernspintomographie zielen darauf ab, die Bildaufnahmezeiten drastisch zu verkürzen. Apparative Weiterentwicklungen, die ein möglichst schnelles Schalten der Magnetfeldgradienten ermöglichen, sind heute an den Grenzen des technisch Machbaren und des für den Patienten physiologisch Zumutbaren angelangt. Für eine Vielzahl von Anwendungen, insbesondere auch für die interventionelle MR-Bildgebung, sind jedoch die Aufnahmezeiten immer noch zu lang.

Eine Überwindung der bestehenden technischen und physiologischen Geschwindigkeitsgrenzen der konventionellen Fourier-Bildgebung scheint durch die in der letzten Zeit bekannt gewordene SENSE-Technik (Sensitivity Encoding) in Aussicht zu sein. Dieser Technik liegt die Erkenntnis zugrunde, dass das räumliche Empfindlichkeitsprofil der Empfangselemente (Resonatoren, Spulen, Antennen) dem Kernspinsignal eine Ortsinformation aufprägt, welche für die Bildrekonstruktion genutzt werden kann. Durch die parallele Verwendung von mehreren, separaten Empfangselementen mit jeweils unterschiedlichen räumlichen Empfindlichkeitsprofilen kann durch Kombination der jeweils detektierten Kernspinsignale die Aufnahmezeit für ein Bild gegenüber der herkömmlichen Fourier-Bildrekonstruktion um einen Faktor reduziert werden, der im günstigen Fall gleich der Anzahl der verwendeten Empfangselemente ist (vgl. Pruessmann et al., Magnetic Resonance in Medicine 42, Seiten 952 bis 962, 1999).

Ein MR-Bildgebungsverfahren der eingangs genannten Art beschreibt beispielsweise die WO 99/54746. Bei diesem vorbekannten Verfahren wird zunächst eine Mehrzahl von MR-Datensätzen unter Benutzung von mehreren Empfangsspulen aufgenommen. Bei jeder der Empfangsspulen hängt die Empfindlichkeit vom Abstand der Kernmagnetisierung zu der betreffenden Spule ab. Die räumlichen Empfindlichkeitsprofile werden bei der Kombination der einzelnen Bilddatensätze ausgenutzt, um ein Bild des Untersuchungsbereiches zu rekonstruieren, das größer ist als der durch die verwendete Pulssequenz vorgegebene Abtastbereich.

Die Veröffentlichung, Research Disclosure 429053, XP-000976393, vom 10.1.2000, offenbart das Prinzip bei einem Magnetresonanzverfahren, z.B. SENSE, Empfindlichkeitsprofile von Empfängerspulen an ihre Position im Magnetresonanzbild anzupassen. Zu dem Zweck sind die Empfängerspulen mit Markern versehen, etwa Mikrospulen. Aus den gemessenen Positionen der Empfängerspulen wird das tatsächliche Empfindlichkeitsprofil abgeleitet, d.h. das Empfindlichkeitsprofil ohne Verschiebungen der Empfängerspulen und daraus folgende Verschiebungen des Empfindlichkeitsprofils.

Die SENSE-Methode bietet sich insbesondere an, wenn die MR-Signale mit Oberflächenspulen aufgenommen werden, die direkt am Patienten angeordnet sind. Derartige Spulen weisen ein stark inhomogenes räumliches Empfindlichkeitsprofil auf, was vorteilhaft für die Bildrekonstruktion mittels SENSE ist. Für die MR-Angiographie kann beispielsweise eine flache HF-Spule unter dem Rücken und eine auf dem Brustkorb eines Patienten platziert werden. Da für die Anwendung der SENSE-Methode das räumliche Empfindlichkeitsprofil der Empfangsspulen genau bekannt sein muss, beginnt die Bildaufnahme mit einer sogenannten Referenzmessung. Bei dieser Referenzmessung wird das volle FOV abgetastet. Die räumlichen Empfindlichkeitsprofile der verwendeten Oberflächenspulen werden dann durch Vergleich der mit den jeweiligen Spulen aufgenommenen Bilddaten gewonnen. Für die Bestimmung der räumlichen Empfindlichkeitsprofile kann dabei mit einer vergleichsweise geringen Bildauflösung gearbeitet werden. Aus diesem Grund lässt sich die Referenzmessung sehr schnell durchführen. Bei der nun folgenden Bildakquisition wird mit einem reduzierten FOV gearbeitet, wobei das volle Bild unter Ausnutzung der ermittelten Empfindlichkeitsprofile durch Kombination der gleichzeitig mit den beiden Oberflächenspulen aufgenommenen MR-Daten rekonstruiert wird. Die Bildaufnahmezeiten sind dabei gegenüber der herkömmlichen Fourier-Bildgebung bei gleicher Bildgröße und -auflösung um einen Faktor 2 reduziert.

Bei der vorbekannten SENSE-Bildgebung ist allerdings nachteilig, dass es im Laufe der Zeit zu Veränderungen in der räumlichen Lage der Empfangsspulen kommen kann. Insbesondere wenn Oberflächenspulen direkt am Patienten angebracht sind, sind Verlagerungen der Empfangsspulen aufgrund von Patientenbewegungen unvermeidbar. Durch eine solche Verlagerung der Empfangselemente werden die zugehörigen räumlichen Empfindlichkeitsprofile derart verändert, dass die Bildrekonstruktion gemäß dem SENSE-Verfahren fehlerhaft ist.

Ausgehend von den genannten Nachteilen liegt der vorliegenden Erfindung die Aufgabe zugrunde, das SENSE-Bildgebungsverfahren zu verbessern, so dass insbesondere eine schnelle Bildakquisition mit hoher Bildqualität auch mit am Patienten angebrachten Oberflächenspulen möglich ist.

Diese Aufgabe wird bei einem MR-Bildgebungsverfahren der eingangs genannten Art dadurch gelöst, dass die räumlichen Empfindlichkeitsprofile bei der Bildrekonstruktion gemäß der bei der Bildakquisition bestehenden räumlichen Lage der Empfangselemente angepasst werden, wobei als Kriterium für die Minimierung von durch die räumliche Verschiebung der Empfindlichkeitsprofile hervorgerufenen Bildartefakten Sprünge in der Bildintensität bewertet werden.

Der vorliegenden Erfindung liegt die grundlegende Erkenntnis zugrunde, dass die räumlichen Empfindlichkeitsprofile, die bei der Bildrekonstruktion gemäß dem SENSE-Verfahren benötigt werden, in Bezug auf die räumliche Lage der verwendeten Empfangselemente festliegen. Mittels einer Referenzmessung können die räumlichen Empfindlichkeitsprofile der einzelnen Empfangselemente mit ausreichender Genauigkeit bestimmt werden. Bei der eigentlichen Bildakquisition auftretende räumliche Verschiebungen und/oder Verdrehungen der Empfangselemente, wie sie beispielsweise durch Bewegungen des Patienten verursacht werden, können auf einfache Weise dadurch kompensiert werden, dass die bei der Referenzmessung bestimmten räumlichen Empfindlichkeitsprofile einer dementsprechenden geometrischen Transformation unterzogen werden. Derartige Korrekturen sind vorteilhafterweise mit den für die Bildrekonstruktion verwendeten gängigen Datenverarbeitungsanlagen ohne weiteres möglich.

Erfindungsgemäß wird also eine schnelle SENSE-Bildgebung ermöglicht, bei der auch dann nur eine einzige Referenzmessung benötigt wird, wenn sich die räumliche Lage der verwendeten Empfangsspulen im Laufe der Zeit, etwa durch Patientenbewegungen, ändert.

Nach Unteranspruch 2 ist es bei dem Verfahren gemäß der Erfindung zweckmäßig, wenn die geometrische Transformation der räumlichen Empfindlichkeitsprofile derart durchgeführt wird, dass Verschiebungen und/oder Verdrehungen der betreffenden Empfangselementen ausgehend von deren Position bei der Referenzmessung nachgebildet werden. Wird, wie oben beschrieben, eine MR-Angiographie durchgeführt, bei der eine Oberflächenspule auf dem Brustkorb des Patienten liegt, so bewegt sich die betreffende Spule der Atembewegung des Patienten folgend auf und ab. Eine geometrische Transformation des räumlichen Empfindlichkeitsprofils gemäß der Erfindung kann in diesem Fall in einer einfachen, eindimensionalen räumlichen Translation bestehen. Es sind aber ohne weiteres auch kompliziertere Verschiebungen denkbar, bei denen alle drei Raumrichtungen betroffen sind und bei denen zusätzlich Verdrehungen berücksichtigt werden müssen.

Denkbar ist es auch, dass die räumlichen Empfindlichkeitsprofile durch Verformungen der Empfangselemente verändert sind. Außerdem kann sich die Feldverteilung im Untersuchungsbereich aus verschiedenen Gründen im Verlauf einer Untersuchung ändern. Wenn nach Anspruch 3 eine Verzerrungskorrektur der Empfindlichkeitsprofile möglich ist, kann Vorteilhafterweise eine nahezu beliebige geometrische Transformation erfolgen, so dass bei der Anpassung der Empfindlichkeitsprofile keine Einschränkungen bestehen. Solche Verzerrungskorrekturen können beispielsweise dadurch bewirkt werden, dass die oben beschriebenen Verschiebungen und/oder Verdrehungen abschnittsweise auf die Empfindlichkeitsprofile angewandt werden.

Für die Bilderzeugung mittels SENSE geeignete Algorithmen, die auf Rekonstruktionseinheiten herkömmlicher MR-Apparaturen ohne weiteres implementierbar sind, sind in der Literatur beschrieben. Derartige Algorithmen erlauben es, die mit reduziertem FOV aufgenommenen Bilddaten unter Ausnutzung der präzisen Kenntnis der räumlichen Empfindlichkeitsprofile zu einem vollständigen Bild des Untersuchungsbereiches zu rekonstruieren. Dabei werden insbesondere die zwangsläufig auftretenden Rückfaltungseffekte (Aliasing) in den mit reduziertem FOV aufgenommenen Bilddaten rückgängig gemacht. Stimmen die bei der Rekonstruktion zugrundegelegten räumlichen Empfindlichkeitsprofile nicht mit der Realität überein, weil sich etwa bei der Bildakquisition die räumliche Lage der Empfangselemente geändert hat, so führt dies zu charakteristischen Bildartefakten. Dies sind insbesondere Fehler in der Bildintensität, was sich in inhomogenen Helligkeitsverläufen im gesamten Bildbereich äußern kann. Schlimmstenfalls kann es zu einer fehlerhaften Rekonstruktion kommen, bei der Reste von Aliasing zurückbleiben, was dazu führt, dass Objekte im Untersuchungsbereich an der falschen Stelle im Bild erscheinen. Dabei wird die Bildrekonstruktion jeweils basierend auf den gleichen MR-Datensätzen unter systematischer Variation der räumlichen Empfindlichkeitsprofile wiederholt durchgeführt. Die mittels einer geeigneten Referenzmessung ermittelten Empfindlichkeitsprofile der verwendeten Empfangselemente sind in der Rekonstruktionseinheit der verwendeten MR-Apparatur gespeichert und können nun (virtuell) derart angepasst werden, dass die im rekonstruierten Bild erscheinenden Artefakte minimiert werden. Da, wie oben beschrieben, die durch Verschiebungen, Verdrehungen und/oder Verzerrungen der Empfangselemente bedingten Bildartefakte charakteristisch sind, ist es auf einfache Weise möglich, diese Artefakte mittels der Rekonstruktionseinheit automatisch zu detektieren und zu bewerten.

Die genannten Bildartefakte treten zwar grundsätzlich im gesamten Bildbereich auf, für das Verfahren gemäß der Erfindung ist es jedoch nach Anspruch 5 ausreichend, wenn die zur automatischen Anpassung der Empfindlichkeitsprofile wiederholt durchgeführte Bildrekonstruktion auf Teile des gesamten Bildbereiches beschränkt wird. Dies ist Vorteilhafterweise deswegen möglich, weil die genannten Bildartefakte an charakteristischen, von vornherein bekannten Stellen im Bild auftreten, die zum Beispiel von der konkreten Wahl des reduzierten FOV abhängen. Deutlich hervortretende Sprünge treten im Bild dort auf, wo die äußeren Grenzen des vollen Bildbereiches durch Aliasing in das reduzierte FOV zurückgefaltet werden. Insbesondere bei der Verwendung von Oberflächenspulen besteht eine erhöhte Empfindlichkeit am Rand des Bildbereiches. Ist das betreffende Empfangselement gegenüber der Referenzmessung verschoben, so sind die beschriebenen Intensitätssprünge deutlich ausgeprägt. Vorteilhafterweise treten die Intensitätssprünge an einer durch die bei der Bildakquisition verwendete Phasenkodierung vorgegebenen Stelle auf, so dass zur erfindungsgemäßen automatischen Anpassung der räumlichen Empfindlichkeitsprofile die SENSE-Rekonstruktion auf die betreffende Stelle beschränkt werden kann, was zu eine erheblichen Zeitersparnis führt.

Zweckmäßig ist es dabei, wenn nach Anspruch 6 benachbarte Bildzeilen miteinander verglichen werden. Erfindungsgemäß müssen dann zur Minimierung der Bildartefakte nur die betreffenden Bildzeilen rekonstruiert und das Verhältnis ihrer Intensitäten berechnet werden. Unmittelbar benachbarte Bildzeilen zeigen etwa die gleiche anatomische Struktur besitzen aber, bedingt durch die Fehlanpassung der räumlichen Empfindlichkeitsprofile, gegebenenfalls unterschiedliche Helligkeiten. Die Empfindlichkeitsdaten werden gemäß der Erfindung so lange durch (virtuelle) geometrische Transformation variiert, bis die beiden benachbarten Bildzeilen möglichst wenig voneinander abweichen.

Alternativ ist es nach Anspruch 7 auch möglich, die Intensitätsprofile des rekonstruierten Bildes selbst zur Bewertung der Fehlanpassung der räumlichen Empfindlichkeitsprofile heranzuziehen. Dies hat den Vorteil, dass sich insbesondere aus den Richtungen der auftretenden Intensitätsgradienten Rückschlüsse auf die Verschiebungen der Empfangselemente ziehen lassen. Dies kann Vorteilhafterweise dazu ausgenutzt werden, die automatische Anpassung der räumlichen Empfindlichkeitsprofile systematischer und damit schneller durchzuführen.

Zur Durchführung des MR-Bildgebungsverfahrens gemäß der Erfindung eignet sich ein MR-Gerät gemäß Anspruch 8. Die Implementierung auf einem üblichen, im klinischen Einsatz befindlichen MR-Tomographen ist also ohne weiteres möglich, ohne dass irgendwelche Anpassungen der Hardware nötig werden. Erforderlich ist lediglich eine Anpassung der Programmierung der Rekonstruktionseinheit. Dies kann mittels eines Computerprogramms zur Steuerung eines MR-Gerätes nach den Ansprüchen 9 und 10 erfolgen. Ein solches Computerprogramm kann den Anwendern von MR-Geräten Vorteilhafterweise auf einem geeigneten Datenträger, wie einer Diskette oder einer CD-ROM, oder zum Herunterladen über ein Datennetz (Internet) zur Verfügung gestellt werden.

Ausführungsbeispiele der Erfindung werden im folgenden anhand der Figuren erläutert. Es zeigen:
- Figur 1: schematische Darstellung des erfindungsgemäßen Verfahrens
- Figur 2: MR-Apparatur gemäß der Erfindung

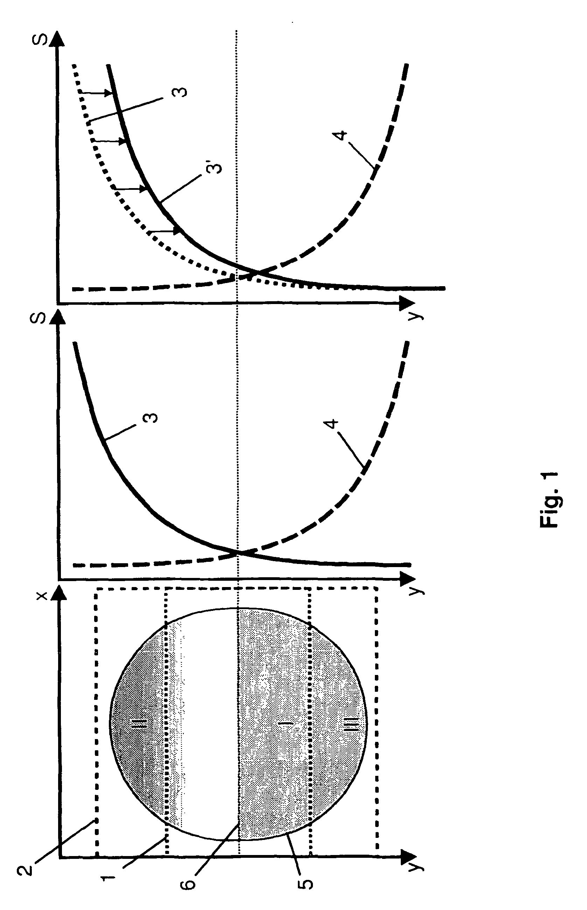

Das linke der in der Figur 1 dargestellten drei Diagramme zeigt die Bildebene mit den Koordinaten x und y. Die Bildaufnahme erfolgt mittels zweier Oberflächenspulen, die in Y-Richtung oberhalb bzw. unterhalb des Bildbereiches positioniert sind Bei der Bildakquisition gemäß der SENSE-Methode werden mit beiden Oberflächenspulen MR-Signale aufgenommen, wobei die Phasenkodierung der verwendeten Pulssequenz so gewählt wind, dass ein reduziertes FOV I abgetastet wird. Der entsprechende Bildbereich ist in der Figur 1 durch eine punktierte Linie 1 gekennzeichnet. Bei der SENSE-Rekonstruktion des Bildes werden außerhalb des FOV I liegende Bildbereiche II, III aus den mit den beiden Oberflächenspulen gemessenen MR-Daten wiederhergestellt. Der volle Bildbereich ist in der Figur 1 durch eine gestrichelte Linie 2 abgegrenzt. Für die SENSE-Rekonstruktion werden Empfindlichkeitsprofile 3 und 4 der beiden Oberflächenspulen benötigt. Die rechten beiden Diagramme zeigen die entsprechenden Abhängigkeiten der Empfindlichkeit S von der Y-Koordinate. Die Empfindlichkeit der oberhalb des Bildbereiches postionierten Oberflächenspule nimmt, wie dem Kurvenverlauf 3 zu entnehmen ist, mit zunehmendem Abstand von der Spule ab. Entsprechendes gilt für das Empfindlichkeitsprofil 4 der unteren Oberflächenspule. Die in dem mittleren Diagramm dargestellten räumlichen Empfindlichkeitsprofile werden bei dem Verfahren gemäß der Erfindung im Wege einer Referenzmessung ermittelt. Bei dieser Referenzmessung wird, wie oben beschrieben, der volle Bildbereich mittels beider Oberflächenspulen abgetastet, worauf die Empfindlichkeitsprofile 3 und 4 durch Vergleich der auf herkömmliche Weise rekonstruierten Bilder bestimmt werden.

In dem linken Diagramm in Figur 1 ist das Bild eines Phantoms 5 zu sehen, das gemäß dem SENSE-Verfahren rekonstruiert wurde, wobei jedoch die oberhalb des Bildbereiches positionierte Oberflächenspule gegenüber der Referenzmessung in Y-Richtung nach unten verschoben ist. Eine derartige Situation kann beispielsweise auftreten, wenn bei einer MR-Angiographie eine der Oberflächenspulen auf dem Brustkorb des Patienten angeordnet ist, so dass die Spule der Atembewegung des Patienten folgend auf und ab bewegt wird. Die bei der Referenzmessung ermittelten Empfindlichkeitsprofile 3 und 4 stimmen also mit der bei der Bildakquisition bestehenden Lage der Empfangsspulen nicht mehr überein. In der Figur 1 sind die dadurch entstehenden charakteristischen Bildartefakte zu erkennen. In der oberen Hälfte des Phantoms 5 nimmt die Bildintensität von oben nach unten bis zur Bildmitte 6 hin kontinuierlich zu. In der Bildmitte 6 treffen die an den oberen und unteren Kanten des reduzierten FOV zurückgefalteten Grenzen des vollen Bildbereiches 2 aufeinander. Die Fehlanpassung des Empfindlichkeitsprofils 3 führt hier zu einem deutlich erkennbaren Intensitätssprung. Die untere Hälfte des Phantoms 5 ist korrekt abgebildet, da die unterhalb des Bildbereiches befindliche Oberflächenspule die bei der Referenzmessung bestehende Position beibehalten hat. Der Intensitätssprung in der Bildmitte 6 kann erfindungsgemäß dazu ausgenutzt werden, die räumlichen Empfindlichkeitsprofile automatisch an die bei der Bildakquisition tatsächlich bestehende räumliche Lage der Empfangselemente anzupassen. Hierzu wird, wie im rechten Diagramm der Figur 1 gezeigt, das zu der oberen Oberflächenspule gehörige Empfindlichkeitsprofil 3 virtuell in Y-Richtung so weit nach unten geschoben, bis die in der Bildmitte 6 aufeinander treffenden Bildzeilen die gleichen Intensitäten aufweisen. Das Ergebnis der Anpassung ist ein neues Empfindlichkeitsprofil 3', das die bei der Bildakquisi tion tatsächlich bestehende Situation korrekt wiedergibt.

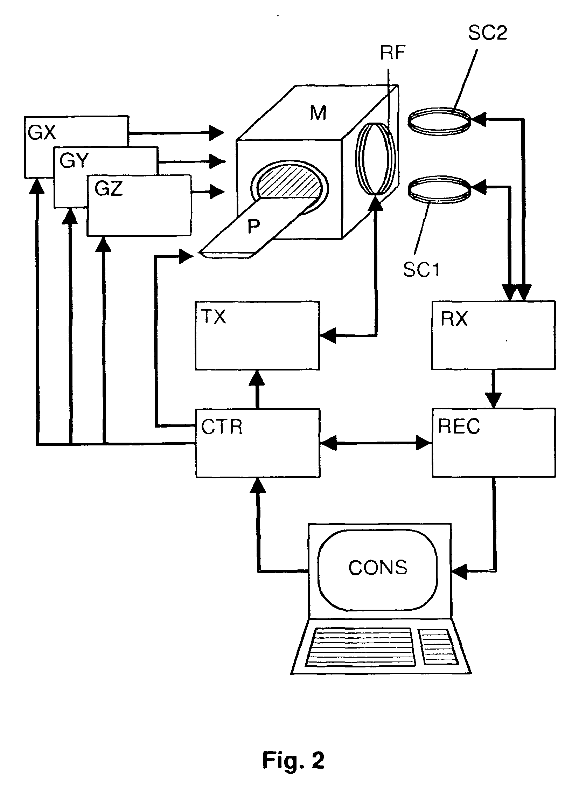

Die Figur 2 zeigt schematisch ein MR-Gerät, das zur Durchführung des erfindungsgemäßen Verfahrens geeignet ist. Im Zentrum der Apparatur steht ein Hauptmagnet M, der in einem Untersuchungsbereich ein im wesentlichen homogenes, stationäres Magnetfeld mit einer Flussdichte von z B. 1,5 Tesla erzeugt. Bei dem Magneten M handelt es sich üblicherweise um einen supraleitenden Elektromagneten. In den Magneten M einfahrbar ist ein Patiententisch P, auf dem sich bei einer Untersuchung ein Patient befindet. Die Feldrichtung des Magneten M verläuft parallel zur Längsrichtung des Patiententisches P. Des weiteren ist eine Anordnung von Gradientenspulen GX, GY, GZ vorgesehen, die über nicht näher dargestellte Gradientenverstärker mit Strom versorgt werden. Damit lassen sich im Untersuchungsbereich die für die verschiedenen Pulssequenzen benötigten Gradientenpulse in beliebigen Raumrichtungen erzeugen. Eine Hochfrequenzspulen-Anordnung RF dient dazu, Hochfrequenzpulse in den Untersuchungsbereich einzustrahlen. Hierzu ist die Spulenanordnung RF mit einem Hochfrequenz-Leistungssender TX verbunden.

Der Sender TX wird von einer Steuereinheit CTR angesteuert, welche zur Erzeugung der benötigten Pulssequenzen auch die Gradientenspulen GX, GY, GZ kontrolliert. Außerdem wird über die Steuereinheit CTR die Position des Patiententisches P variiert. Eine Rekonstruktionseinheit REC digitalisiert und speichert die vom Empfänger RX übermittelten MR-Signale und rekonstruiert daraus erfindungsgemäß Bilder des Untersuchungsbereiches Der Empfänger RX dient dazu, die mit zwei Oberflächenspulen SC1 und SC2 aufgenommenen MR-Signale zu registrieren. Die beiden Oberflächenspulen SC1 und SC2 weisen stark voneinander abweichende räumliche Empfindlichkeitsprofile auf, was für die Anwendung der SENSE-Methode vorteilhaft ist. In der Rekonstruktionseinheit REC sind die Empfindlichkeitsdaten der beiden Oberflachenspulen SC1 und SC2 gespeichert. Diese können beipielsweise, wie oben beschrieben, im Wege einer Referenzmessung gewonnen werden. Zur Durchführung des erfindungsgemäßen Verfahrens weist die Rekonstruktionseinheit REC eine Programmierung auf, mit der es möglich ist, die gespeicherten Empfindlichkeitsdaten virtuell gemäß der bei der Akquisition der MR-Daten bestehenden räumlichen Lage der Empfangselemente SC1 und SC2 anzupassen. Die Rekonstruktions einheit REC steht ferner mit einer Bedienungskonsole CONS in Verbindung, die über einen Monitor verfügt, auf dem die rekonstruierten Bilddaten dargestellt werden. Die Konsole CONS dient gleichzeitig dazu, die gesamte Apparatur zu bedienen und die gewünschten Pulssequenzen zu initiieren. Hierzu steht die Konsole CONS außerdem mit der Steuereinheit CTR in Verbindung. Eine zusätzliche Verbindung besteht zwischen der Steuereinheit CTR und der Rekonstruktionseinheit REC. Diese wird dazu benötigt, die bei der Bildakquisition verwendete Phasenkodierung an die Rekonstruktionseinheit REC zu übermitteln, da diese Daten für die Bildrekonstruktion benötigt werden.

## Patentansprüche

1. MR-Bildgebungsverfahren, bei dem eine Anzahl von MR-Datensätzen zu einem Bild der Kernmagnetisierungsverteilung in einem Untersuchungsbereich kombiniert wird, wobei ausgenutzt wird, dass jedem MR-Datensatz ein räumliches Empfindlichkeitsprofil (3, 4) eines für die Akquisition des jeweiligen MR-Datensatzes verwendeten Empfangselementes zugeordnet ist, wobei
die räumlichen Empfindlichkeitsprofile (3, 4) bei der Bildrekonstruktion gemäß der bei der Bildakquisition bestehenden räumlichen Lage der Empfangselemente angepasst werden,
**dadurch gekennzeichnet,**
**dass** als Kriterium für die Minimierung von durch die räumliche Verschiebung der Empfindlichkeitsprofile hervorgerufenen Bildartefakten Sprünge in der Bildintensität bewertet werden.

2. Verfahren nach Anspruch 1,
**dadurch gekennzeichnet,**
**dass** die Anpassung darin besteht, die räumlichen Empfindlichkeitsprofile (3, 4) derart zu variieren, dass Verschiebungen und/oder Verdrehungen eines Empfangselementes gegenüber einer entsprechenden Referenzposition desselben Empfangselementes nachgebildet werden.

3. Verfahren nach Anspruch 1,
**dadurch gekennzeichnet,**
**dass** die Anpassung in einer Verzerrungskorrektur der räumlichen Empfindlichkeitsprofile besteht.

4. Verfahren nach Anspruch 1,
**dadurch gekennzeichnet,**
**dass** die Anpassung automatisch erfolgt, indem die Bildrekonstruktion basierend auf den gleichen MR-Datensätzen so lange unter Variation der räumlichen Empfindlichkeitsprofile (3, 4) wiederholt wird, bis durch Verschiebungen und/oder Verdrehungen der Empfangselemente bedingte Bildartefakte minimiert sind.

5. Verfahren nach Anspruch 4,
**dadurch gekennzeichnet,**
**dass** die Bildrekonstruktion bei der Minimierung der Bildartefakte auf Teile des gesamten Bildbereiches beschränkt wird.

6. Verfahren nach Anspruch 5,
**dadurch gekennzeichnet,**
**dass** zur Bewertung von Sprüngen in der Bildintensität benachbarte Bildzeilen miteinander verglichen werden.

7. Verfahren nach Anspruch 4,
**dadurch gekennzeichnet,**
**dass** als Kriterium für die Minimierung der Bildartefakte Gradienten in der Bildintensität bewertet werden.

8. MR-Gerät zur Durchführung des Verfahrens nach Anspruch 1, mit einer Gradientenspulen-Anordnung (GX, GY, GZ) zur Erzeugung von Magnetfeldgradienten, einer Hochfrequenzspulen-Anordnung (RF) zur Erzeugung von Hochfrequenzpulsen, wenigstens zwei Empfangsspulen (SC1, SC2) mit unterschiedlichen räumlichen Empfindlichkeitsprofilen zum Empfang von MR-Signalen aus einem Untersuchungsbereich, eine Steuereinheit (CTR), durch welche die Gradienten- und Hochfrequenzspulen zur Einstrahlung von Bildgebungs-Pulssequenzen in einen Untersuchungsbereich angesteuert werden, und mit einer Rekonstruktionseinheit (REC) mittels welcher MR-Daten und räumliche Empfindlichkeitsdaten gespeichert und verarbeitet werden, wobei die Rekonstruktionseinheit (REC) derart programmiert ist, dass die räumlichen Empfindlichkeitsdaten bei der Bildrekonstruktion gemäß der bei der Akquisition der MR-Daten bestehenden räumlichen Lage der Empfangselemente angepasst werden,
**dadurch gekennzeichnet,**
**dass** als Kriterium für die Minimierung von durch die räumliche Verschiebung der Empfindlichkeitsprofile hervorgerufenen Bildartefakten Sprünge in der Bildintensität bewertet werden.

9. Computerprogramm zur Steuerung eines MR-Gerätes nach Anspruch 8,
**dadurch gekennzeichnet,**
**dass** das Programm die MR-Daten unter Ausnutzung der räumlichen Empfindlichkeitsprofile kombiniert, wobei die Empfindlichkeitsdaten an die bei der Bildakquisition bestehende räumliche Lage der Empfangselemente angepasst werden, wobei als Kriterium für die Minimierung von durch die räumliche Verschiebung der Empfindlichkeitsprofile hervorgerufenen Bildartefakten Sprünge in der Bildintensität bewertet werden.

10. Computerprogramm nach Anspruch 9,
**dadurch gekennzeichnet,**
**dass** das Programm die Bildrekonstruktion basierend auf den gleichen MR-Daten wiederholt so lange unter Variation der räumlichen Empfindlichkeitsprofile durchführt, bis durch Verschiebungen und/oder Verdrehungen der Empfangselemente bedingte Bildartefakte minimiert sind.

## Claims

1. An MR imaging method in which a number of MR data sets is combined so as to form an image of the nuclear magnetization distribution in an examination zone while utilizing the fact that a spatial sensitivity profile (3, 4) of a receiving element used for the acquisition of the relevant MR data set is associated with each MR data set, wherein during the image reconstruction the spatial sensitivity profiles (3, 4) are adapted in conformity with the position in space of the receiving elements during the image acquisition,
**characterized in that** gradients in the image intensity are evaluated as a criterion for minimizing the image artifacts generated by the spatial displacement of the sensitivity profiles.

2. A method as claimed in claim 1, **characterized in that** the adaptation consists in varying the spatial sensitivity profiles (3, 4) such that displacements and/or rotations of a receiving element relative to a respective reference position of that same receiving element are simulated.

3. A method as claimed in claim 1, **characterized in that** the adaptation consists of a deformation correction of the spatial sensitivity profiles.

4. A method as claimed in claim 1, **characterized in that** the adaptation is performed automatically by repeating the image reconstruction on the basis of the same RF data sets while varying the spatial sensitivity profiles (3, 4) until image artifacts that are due to displacements and/or rotations of the receiving elements have been minimized.

5. A method as claimed in claim 4, **characterized in that** during the minimizing of the image artifacts the image reconstruction is limited to portions of the overall image region.

6. A method as claimed in claim 5, **characterized in that** neighboring image lines are compared with one another in order to evaluate gradients in the image intensity.

7. A method as claimed in claim 4, **characterized in that** gradients in the image intensity are evaluated as a criterion for minimizing the image artifacts.

8. An MR apparatus for carrying out the method claimed in claim 1, which apparatus includes a gradient coil system (GX, GY, GZ) for generating magnetic field gradients, an RF coil system (RF) for generating RF pulses, at least two receiving coils (SC1, SC2) that have different spatial sensitivity profiles and serve to receive MR signals from an examination zone, a control unit (CTR) that controls the gradient coils and RF coils so as to apply imaging pulse sequences to an examination zone, and a reconstruction unit (REC) which stores and processes MR data and spatial sensitivity data, wherein the reconstruction unit (REC) is programmed in such a manner that during the image reconstruction the spatial sensitivity data is adapted in conformity with the position in space of the receiving elements during the acquisition of the MR data, **characterized in that** gradients in the image intensity are evaluated as a criterion for minimizing the image artifacts generated by the spatial displacement of the sensitivity profiles.

9. A computer program for controlling an MR apparatus as claimed in claim 8, **characterized in that** the program combines the MR data while utilizing the spatial sensitivity profiles, the sensitivity data being adapted to the position in space of the receiving elements during the image acquisition, while gradients in the image intensity are evaluated as a criterion for minimizing the image artifacts generated by the spatial displacement of the sensitivity profiles.

10. A computer program as claimed in claim 9, **characterized in that** the program repeats the image reconstruction on the basis of the same MR data while varying the spatial sensitivity profiles until image artifacts that are due to displacements and/or rotations of the receiving elements have been minimized.

## Revendications

1. Procédé de reconstruction d'images RM dans lequel un nombre de jeux de données RM est combiné en une image de la distribution de la magnétisation nucléaire dans une zone d'examen, dans lequel on exploite le fait qu'un profil de sensibilité spatial (3, 4) d'un élément de réception utilisé pour l'acquisition du jeu de données RM respectif est affecté à chaque jeu de données M, dans lequel
les profils de sensibilité spatiaux (3, 4) sont adaptés pour la reconstruction de l'image selon la position spatiale des éléments récepteurs existant pour l'acquisition de l'image,
**caractérisé en ce**
**que** les sauts dans l'intensité de l'image sont évalués comme critère pour la minimisation d'artefacts de l'image provoqués par le déplacement spatial des profils de sensibilité.

2. Procédé selon la revendication 1,
**caractérisé en ce**
**que** l'adaptation consiste à faire varier les profils de sensibilité spatiaux (3, 4) de telle sorte que les déplacements et/ou rotations d'un élément récepteur soient reproduits par rapport à une position de référence correspondante du même élément récepteur.

3. Procédé selon la revendication 1,
**caractérisé en ce**
**que** l'adaptation consiste en une correction du redressement des profils de sensibilité spatiaux.

4. Procédé selon la revendication 1,
**caractérisé en ce**
**que** l'adaptation est effectuée automatiquement en répétant la reconstruction de l'image sur la base des même jeux de données RM avec variation des profils de sensibilité spatiaux (3, 4) jusqu'à ce que les artefacts d'image provoqués par des déplacements et/ou rotations des éléments récepteurs soient minimisés.

5. Procédé selon la revendication 4,
**caractérisé en ce**
**que** la reconstruction de l'image est limitée en cas de minimisation des artefacts d'image à des parties de la zone d'image complète.

6. Procédé selon la revendication 5,
**caractérisé en ce**
**que**, pour l'évaluation de sauts dans l'intensité de l'image, des lignes d'image voisines sont comparées l'une à l'autre.

7. Procédé selon la revendication 4,
**caractérisé en ce**
**que** des gradients dans l'intensité de l'image sont évaluées comme critère pour la minimisation des artefacts de l'image.

8. Appareil RM pour l'exécution du procédé selon la revendication 1, avec un agencement de bobines à gradient (GX, GY, GZ) pour la production de gradients de champ magnétique, un agencement de bobines à haute fréquence (RF) pour la production de bobines à haute fréquence, au moins deux bobines de réception (SC1, SC2) avec différents profils de sensibilité spatiaux pour la réception de signaux RM à partir d'une zone d'examen, une unité de commande (CTR) par laquelle les bobines à gradient et à haute fréquence sont commandées pour le rayonnement de séquences à impulsion d'imagerie dans une zone d'examen et avec une unité de reconstruction (REC) à l'aide de laquelle les données RM et les données de sensibilité spatiales sont enregistrées et traitées, l'unité de reconstruction (REC) étant programmée de telle sorte que les données de sensibilité spatiales sont adaptées pour la reconstruction de l'image conformément à la position spatiale des éléments de réception existant lors de l'acquisition des donnée RM,
**caractérisé en ce**
**que** les sauts dans l'intensité de l'image sont évalués comme critère pour la minimisation des artefacts de l'image provoqués par le déplacement spatial des profils de sensibilité.

9. Programme informatique pour la commande d'un appareil RM selon la revendication 8,
**caractérisé en ce**
**que** le programme combine les données RM en utilisant les profils de sensibilité spatiaux, les données de sensibilité étant adaptées à la position spatiale des éléments récepteurs existant lors de l'acquisition de l'image,
**que** les sauts dans l'intensité de l'image sont évalués comme critère pour la minimisation des artefacts de l'image provoqués par le déplacement spatial des profils de sensibilité.

10. Programme informatique selon la revendication 9,
**caractérisé en ce**
**que** le programme de la reconstruction d'image basé sur les mêmes données RM est répété avec variation des profils de sensibilité spatiaux jusqu'à ce que les artefacts induits par des déplacements et/ou rotations des éléments récepteurs soient minimisés.
